Europäisches Patentamt

European Patent Office

Office européen des brevets

(11) Publication number: **0 035 331**

**B1**

(12) EUROPEAN PATENT SPECIFICATION

(45) Date of publication of patent specification: **22.05.85**

(21) Application number: **81300546.9**

(22) Date of filing: **10.02.81**

(51) Int. Cl.⁴: **H 01 L 23/30, H 01 L 27/06**

(54) Resin-sealed semiconductor device.

(30) Priority: **29.02.80 JP 25142/80**

(43) Date of publication of application:
**09.09.81 Bulletin 81/36**

(45) Publication of the grant of the patent:
**22.05.85 Bulletin 85/21**

(84) Designated Contracting States:
**DE FR GB**

(56) References cited:
**GB-A-2 000 638
GB-A-2 000 639
GB-A-2 000 640
GB-A-2 001 195**

(73) Proprietor: **Kabushiki Kaisha Toshiba
72, Horikawa-cho Saiwai-ku
Kawasaki-shi Kanagawa-ken 210 (JP)**

(72) Inventor: **Suzuki, Kouji
240 Sanmai-cho Kanagawaku
Yokohama-shi (JP)**
Inventor: **Aoki, Toshio
26-2-203, Daikan-cho
Hiratsuka-shi Kanagawa-ken (JP)**
Inventor: **Kusanagi, Sachie
241-2, Sanmai-cho Kanagawa-ku
Yokohama-shi (JP)**

(74) Representative: **Freed, Arthur Woolf
MARKS & CLERK 57-60 Lincoln's Inn Fields
London WC2A 3LS (GB)**

## Description

This invention relates to a semiconductor device comprising a plurality of resistor elements, and more particularly to a resin-sealed semiconductor device constructed by sealing a semiconductor plate in an electrically insulating synthetic resin.

With a semiconductor device, a semiconductor plate is generally sealed in an envelope to protect a drive element, prevent the deterioration of its property and sustain its electric property over a long period of time. An envelope prepared from electrically insulating synthetic resin is characterized in that it can be manufactured with ease, at low cost and in quantities. In recent years, a synthetic resin envelope has come to be applied more widely for the protection of a high power type semiconductor device due to improvements on synthetic resin material and developments of a synthetic resin-sealing technique.

Such high power type semiconductor device is constructed by fixing a semiconductor comprising active and passive elements such as resistor elements on a metal mount, electrically connecting these drive elements to metal leads each acting as an electrode terminal, and finally sealing the semiconductor plate in an envelope prepared from electrically insulating synthetic resin. Where a high power type semiconductor device is manufactured, a semiconductor plate is placed on a heat-releasing substrate made of copper or aluminum.

GB—A—2 000 639 discloses a semiconductor device having an envelope of a plastics resin with a single crystal silicon plate of rectangular shape sealed in the envelope. The cross-wise sides of the plate undergo stresses of a different magnitude from those applied to the lengthwise sides of the plate and the main plane is formed of {100}, {811}, {511}, or {111} crystal plane. A pair of resistor elements are formed in the main plane of the single crystal silicon plate to extend at right angles with each other.

With a resin-sealed semiconductor device, wide variations appear in the thermal expansion coefficients of a resinous material constituting an envelope, semiconductor plate, and metal mount or heat-releasable substrate made of, for example, copper or aluminum. Therefore a great stress is applied to a semiconductor plate when it is sealed in a synthetic resin envelope and later heat treated. This great stress gives rises to changes in the electric properties of the drive elements of a semiconductor plate from those which are realized before it is sealed in a synthetic resin envelope. As a result, the drive elements undesirably fail to maintain the properties demanded thereof. The above-mentioned great stress exerts a prominently harmful effect particularly on an integrated semiconductor device comprising linear circuits, resulting in a noticeable decline in the yield of said semiconductor device.

It is accordingly an object of this invention to provide a synthetic resin-sealed semiconductor device whose electric properties are little likely to be reduced even after said device is sealed in a synthetic resin envelope and consequently can be manufactured with good yield.

According to this invention there is provided a synthetic resin-sealed semiconductor device comprising an envelope made of a synthetic resin a single crystal silicon plate which is formed with a rectangular shape and sealed in the envelope, the crosswise sides of said plate undergoing stresses of a different magnitude from those applied to the lengthwise sides of said plate, and the main plane being formed of {100}, {811}, {511}, or {111} crystal plane; and at least a pair of resistor elements formed in the main plane of the single crystal silicon plate to extend at right angles with each other, characterized in that the lengthwise sides and the crosswise sides of the envelope form a rectangle and that the lengthwise sides of the single crystal silicon plate and the direction in which the pair of resistor elements extend defines an angle of substantially 45° with the lengthwise sides of the envelope.

This invention can be more fully understood from the following detailed description when taken in conjunction with the accompanying drawings, in which:—

Fig. 1 is a plane view of a synthetic resin-sealed semiconductor device set forth to explain the fundamental concept of this invention;

Figs. 2A and 2B collectively show a semiconductor device according to a first embodiment of this invention; wherein in Fig. 2A is a plan view, and

Fig. 2B is a sectional view;

Figs. 3A and 3B collectively indicated a semiconductor device according to a second embodiment of the invention: wherein Fig. 3A is a plan view, and Fig. 3B is a sectional view;

Figs. 4A and 4B jointly set forth a semiconductor device according to a third embodiment of the invention: wherein Fig. 4A is a plan view, and Fig. 4B is a sectional view;

Figs. 5 to 7 indicate relationships between differences in the conductivity type and/or main crystal plane of a single crystal silicon substrate and variations in the resistances of resistor elements as determined from the synthetic resin-sealed semiconductor devices of both prior art and present invention; and

Figs. 8A to 8H are curve diagrams showing relationships between differences in the conductivity type and/or main crystal plane of a single crystal silicon substrate and variations in the resistances of a pair of resistor elements as determined from the synthetic resin-sealed semiconductor devices of both prior art and present invention.

For better understanding of this invention, description is given of a fundamental concept on which the invention is based.

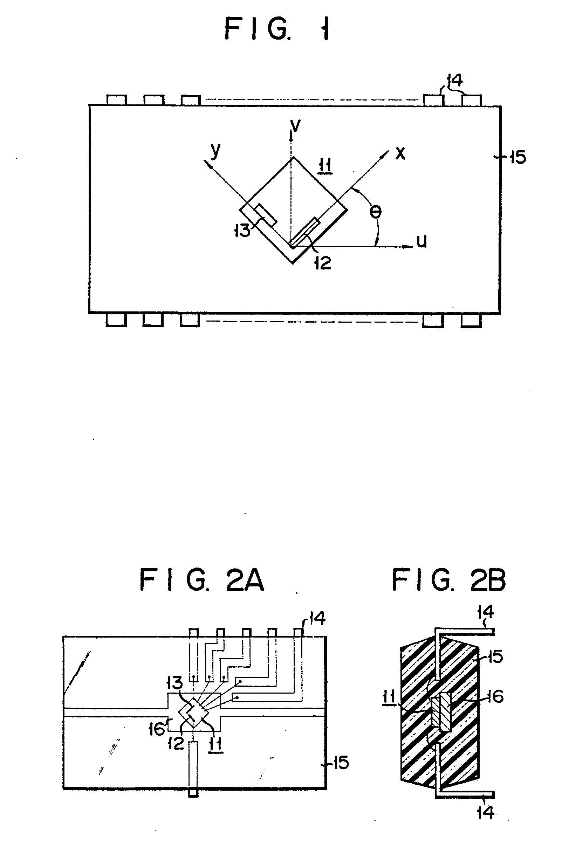

Fig. 1 is a schematic plan view of a synthetic resin-sealed semiconductor device embodying this invention. Reference numeral 11 denotes a semiconductor plate which is formed with a rectangular cross section and comprises transistors and diodes (not shown) used as active elements and resistor elements used as passive elements. Said active and passive elements are formed in a single crystal silicon substrate having a rectangular cross section (oblong or square cross section). The resistor elements 12, 13 are constructed by forming regions by impurity diffusion or ion implantation to conduct electric current in parallel with and perpendicularly to the direction of a <110> crystal axis of a single crystal silicon substrate where its main plane is formed of, for example, a (100) crystal plane and thereafter being fitted with an electrode. These resistor elements 12, 13 are generally formed in any other portion of a single crystal silicon substrate than its peripheral edge portion. A semiconductor plate 11 thus constructed is fixed on a metal mount or heat-releasable metal substrate. The semiconductor plate 11 is sealed in an envelope 15 which is prepared from electrically insulating synthetic resin material with a rectangular cross section in a state connected by wire bonding to metal leads 14 set around said metal mount or substrate. The electrically insulating synthetic resin material is formed of, for example, phenol novolak type epoxy resin. The envelope 15 prepared from said synthetic resin material is chosen to have a length of 19 mm, width of 6.3 mm and thickness of 3.5 mm. The envelope 15, semiconductor pellet 11 and resistor elements 12, 13 are so positioned that the semiconductor plate 11 is set substantially at the center of the envelope 15; the sides of the rectangular cross section of the semiconductor plate 11 define an angle of $45° \pm 5°$ with sides of the envelope 15; the resistor elements 12, 13 formed in the semiconductor plate 11 define an angle of $90° \pm 5°$ with each other, and extend substantially in parallel with the corresponding sides of the semiconductor pellet 11.

With a synthetic resin-sealed semiconductor device constructed as described above, it is possible to reduce effects exerted by anisotropic resistance changes caused by those variation in the stresses applied to the sides of the semiconductor plate 11 which are caused by the different thicknesses of the side walls of the synthetic resin envelope 15. Therefore, differences in the electric properties of a semiconductor plate 11 between before and after its seal in the synthetic resin envelope 15 can be minimized, thus giving full play to the property of the semiconductor plate 11.

The reason for the above-mentioned merits of this invention runs as follows. Fig. 1 shows a u—v—w coordinate system of the rectangular synthetic resin envelope 15 used with a semiconductor device constructed as described above, in which u denotes the lengthwise axis of the rectangular envelope 15; v shows the crosswise axis; and w represents the axis extending along the thickness of said rectangular envelope 15. The resistor element is also indicated by an x—y—z coordinate system, in which x axis shows the direction in which the resistor element 12 of the semiconductor pellet 11 extends, that is, current direction; y axis denotes the direction in which the resistor element 13 perpendicular to the resistor element 12 extends or current direction; and z axis indicates a direction along the thickness of a single crystal silicon substrate. In this case the w axis and z axis mean the same axis. The x axis is inclined to the u axis at an angle $\theta$ of about $45°$ $(\pm 5°)$.

Those changes in the resistance of the resistor elements 12, 13 which occur when the semiconductor element 11 is sealed in the synthetic resin envelope 15 may be regarded as resulting from a piezoelectric resistance caused by a stress applied to the semiconductor pellet 11. Now let it be assumed that $R_0$ represents the resistance of the resistor element 12 (or 13) in the absence of a stress; and $\Delta R$ denotes the variation in said resistance which is caused by a stress. The rate of said variation is generally expressed by the following formula:

$$\delta\rho_i = \Delta R/R_c = \sum_{j=1}^{6} \pi'_{ij} \cdot T_j \qquad (1)$$

where:

suffix i = a sense of a direction toward which current runs through the resistor elements 12, 13

$\pi'_{ij}$ = a constant defined by the direction in which the resistance of the resistor element extending in the above-mentioned direction is applied, the conductivity type of said resistor, element and the concentration at which an impurity is diffused to form said resistor element

$T_j$ = stresses applied in various directions

Where the stresses and shearing stresses applied in various directions are expressed as $\sigma_x$, $\sigma_y$, $\sigma_z$, $\tau_{yz}$, $\tau_{zx}$, $\tau_{xy}$, then the above-mentioned formula (1) may be rewritten as follows:

$$\delta\rho_i = \pi'_{i1} \cdot T_1 + \pi'_{i2} \cdot T_2 + \pi'_{i3} \cdot T_3$$

$$+ \pi'_{i4} \cdot T_4 + \pi'_{i5} \cdot T_5 + \pi'_{i6} \cdot T_6$$

$$= \pi'_{i1} \cdot \sigma_x + \pi'_{i2} \cdot \sigma_y + \pi'_{i3} \cdot \sigma_z$$

$$+ \rho'_{i4} \cdot \tau_{yz} + \pi'_{i5} \cdot \tau_{zx} + \pi'_{i6} \cdot \tau_{xy} \qquad (2)$$

With the resistor element 12 extending along the x axis, the following equation results:

$$\delta\rho_1 = \delta\rho_x \qquad (3a)$$

With the resistor element 13 extending along the y axis, the following equation is established:

$$\delta\rho_2 = \delta\rho_y \qquad (3b)$$

With the conventional synthetic resin-sealed semiconductor device in which a semiconductor pellet is made to extend in the lengthwise direction of a rectangular envelope and which is provided with a metal mount, stresses applied to the center of the semiconductor pellet are regarded as having about the following values:

$$\sigma_u = -1{,}600 \ \mathrm{kg \cdot cm^{-2}}$$

$$\sigma_v = -1{,}400 \ \mathrm{kg \cdot cm^{-2}}$$

$$\tau_{uv} = -40 \ \mathrm{kg \cdot cm^{-2}}$$

The minus notation $(-)$ given in the above formulas denotes a degree of compression. Data shown above were obtained from a semiconductor device constructed by fixing a single crystal silicon pellet having a thickness of 0.3 mm and a size of $3 \times 3$ mm$^2$ on a metal mount 2 and sealing said pellet in an envelope which was prepared from phenol novolak type epoxy resin and had a length of 19 mm, width of 6.3 mm and thickness of 3.5 mm.

The following stresses:

$$\sigma_u = -700 \ \mathrm{kg \cdot cm^{-2}}$$

$$\sigma_v = -800 \ \mathrm{kg \cdot cm^{-2}}$$

$$\tau_{uv} = -10 \ \mathrm{kg \cdot cm^{-2}}$$

were applied to the center of the conventional synthetic resin-sealed semiconductor device which was constructed by fixing a single crystal silicon pellet having a thickness of 0.3 mm and a size of $3 \times 3$ mm$^2$ on a heat-releasable copper plate having a thickness of 2 mm, and sealing said pellet in a rectangular envelope prepared from phenol novolak type epoxy resin with a thickness of 3 mm, length of 30 mm and width of 15 mm, in a state extending in the lengthwise direction of said envelope.

As seen from the above data, the shearing stress $\tau_{uv}$ occurring in the conventional synthetic resin-sealed semiconductor device is much smaller than the stresses $\sigma_u$ and $\sigma_v$ and can be practically overlooked. Where a single crystal silicon plate has a far greater (practically over three times greater) length and width than its thickness, then the stress $\sigma_w$ and shearing stresses $\tau_{wu}$, $\tau_{vw}$ (though not shown in the above indication of data) are small and can be substantially overlooked. This fact may be expressed as follows:

$$\sigma_u, \ \sigma_v \gg \tau_{uv}, \ \sigma_w, \ \tau_{wu}, \ \tau_{vw} \qquad (4)$$

Therefor, $\sigma_u$ and $\sigma_v$ may be regarded as the only stresses that are applied to the single crystal silicon pellet.

Where $\theta$ is taken to denote an angle defined by the x axis with the u axis, then the stresses $\sigma_x$ and $\sigma_y$ applied in the directions of the x and y axes in which the resistor elements 12, 13 respectively extend may be approximately expressed as follows:

$$\sigma_x \simeq \sigma_u \cos^2\theta + \sigma_v \sin^2\theta \qquad (4a)$$

$$\sigma_y \simeq \sigma_u \sin^2\theta + \sigma_v \cos^2\theta \qquad (4b)$$

As previously described, the above-mentioned angle $\theta$ is chosen to be substantially 45° (45°±5°) in a synthetic resin-sealed semiconductor device embodying this invention.

Therefore,

$$\sigma_x \simeq \sigma_y \qquad (5)$$

Namely, the stresses $\sigma_x$ and $\sigma_y$ are applied to a single crystal silicon plate used with the present semiconductor device. Rates of variations $\delta\rho_x$ and $\delta\rho_y$ (given in the formulas (3a) and (3b)) in the resistances of the resistor elements 12, 13 may respectively be approximately expressed as follows:

$$\delta\rho_x \simeq \pi'_{11}\sigma_x + \pi'_{12}\sigma_y \qquad (6a)$$

$$\delta\rho_y \simeq \pi'_{22}\sigma_y + \pi'_{21}\sigma_x \qquad (6b)$$

In case of $\pi'_{11} = \pi'_{22}$ and $\pi'_{12} = \pi'_{21}$, therefore, the rates of the above-mentioned variations $\delta\rho_x$ and $\delta\rho_y$ may be taken to be substantially equal to each other as $\delta\rho_x \simeq \delta\rho_y$.

Thus, the rates of variations in the resistances of the resistor elements 12, 13 defining an angle of 90° with each other as previously mentioned can be made equal to each other. As a result, it is possible to suppress variations in, for example, the D.C. bias voltage level of active elements used with the semiconductor plate 11, thereby eliminating differences in the electric properties of the semiconductor pellet 11 between before and after its seal in a synthetic resin envelope.

As seen from the foregoing description, the synthetic resin-sealed semiconductor device embodying this invention has the advantages that the device displays noticeably favorable effects when applied to variation types of linear integrated circuits; semiconductor circuit elements can be simply designed; since variations in the resistances of the resistor elements 12, 13 can be estimated in advance, it is possible to design an optimum integrated circuit with said resistance variations taken into account; and eventually the subject semiconductor device can be manufactured with high yield and prominent practical merits.

Description is now given with reference to the accompanying drawings of the arrangement and operation of a synthetic resin-sealed semiconductor device according to a first embodiment of this invention.

Referring to a synthetic resin-sealed semiconductor device of Figs. 2A and 2B, a metal mount 16 having a rectangular cross section is set in an envelope 15 which has a rectangular cross section, and whose lengthwise wall is made longer than the crosswise wall, in such a manner that the lengthwise axis of said metal mount 16 is aligned with the lengthwise axis of said envelope 15. A single crystal silicon plate 11 having a rectangular cross section is fixed on the metal mount 16, in such a manner that the sides of the said silicon plate 11 define an angle of 45° with those of said metal mount 16. A pair of resistors 12, 13 extending at right angles to each other are formed on the surface of the silicon plate 11 with the axes of the sides of said resistors 12, 13 so set as to define an angle of 45° with the lengthwise axis of the envelope 15. Electrodes (not shown) are respectively provided at both ends of each of the resistor elements 12, 13. The electrodes are electrically connected to metal leads 14, enabling electric current to flow lengthwise of the resistor element 11.

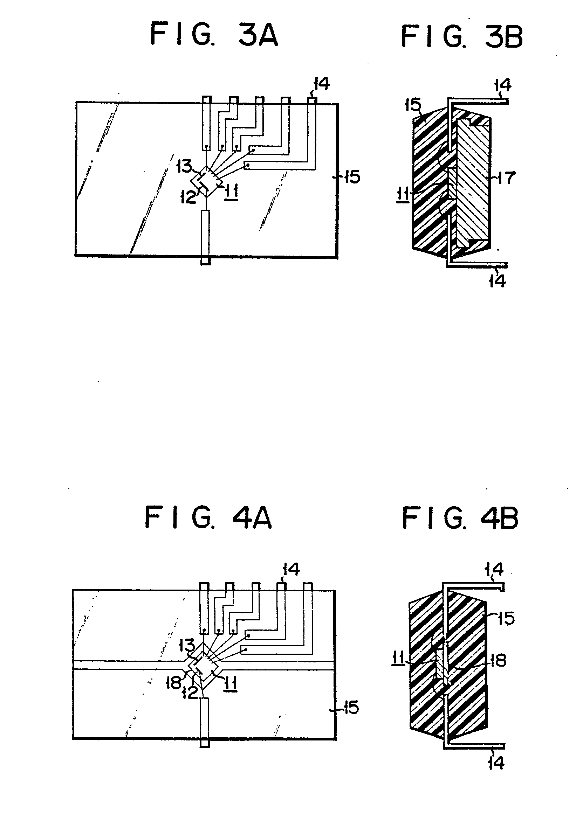

Figs. 3A and 3B show a synthetic resin-sealed semiconductor device according to a second embodiment of the invention. This semiconductor device is constructed by mounting a single crystal silicon plate 11 on a heat-releasable metal plate 17 in such a manner that the sides of said silicon plate 11 define an angle of 45° with those of said heat-releasable metal plate 17.

The semiconductor device of Figs. 3A and 3B allows for the direct application of the various mounts used with the conventional semiconductor device, offering the advantage of making it possible to utilize the prior art production line without any substantial alteration of the manufacturing process.

A synthetic resin-sealed semiconductor device of Figs. 4A and 4B according to a third embodiment of this invention is constructed by so setting a rectangular metal mount 18 itself as to cause its sides to define an angle of substantially 45° with the lengthwise axis of the envelope 15, and forming a rectangular single crystal silicon plate 11 in such a manner that the sides of said plate 11 are aligned with those of the metal mount 18. The above-mentioned arrangement makes it possible to easily define the position of the silicon plate 11 relative to the envelope 15 simply by aligning the position of said silicon plate 11 with that of the metal mount 18, offering the advantage of facilitating the manufacture of a synthetic resin-sealed semiconductor device. In this connection, it is very advantageous to mark the prescribed parts of the metal mounts 16, 18 and heat-releasable metal plate 17 with specific notations for defining the directions in which they are set in place relative to the silicon plate 11.

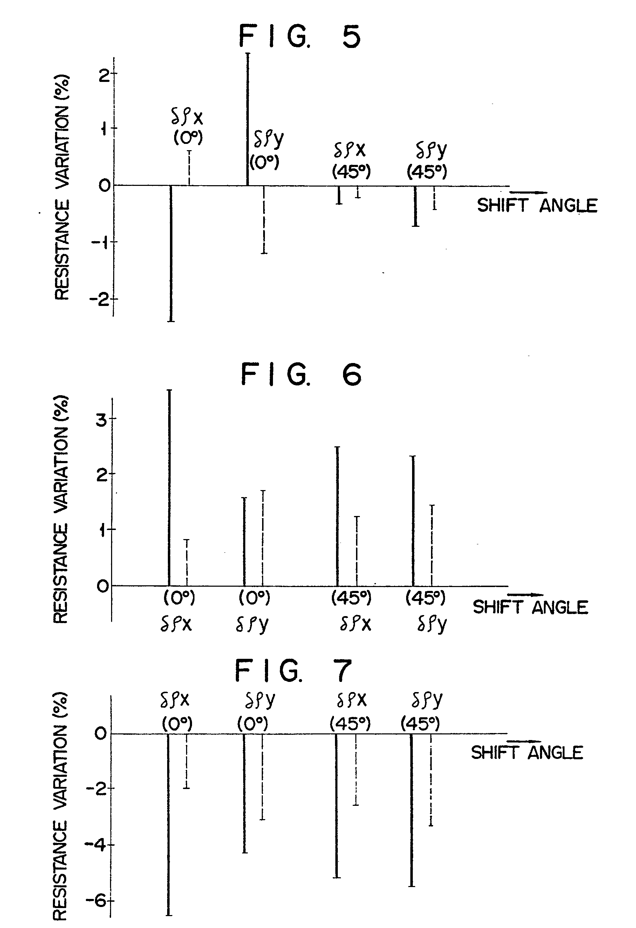

Description is now given with reference to Figs. 5 to 7 of concrete data on a synthetic resin-sealed semiconductor device embodying this invention in comparison with those of a similar semiconductor device of the prior art. As previously described, Figs. 5 to 7 indicate relationships between differences in the conductivity type and/or main crystal plane of a single crystal silicon substrate and variations in the resistances of resistor elements. Solid lines represent data on a synthetic resin-sealed semiconductor device according to a first embodiment of this invention which is constructed by fixing a semiconductor element 11 on a metal mount 16 as shown in Figs. 2A and 2B. Broken lines denote data on a high power type synthetic resin-sealed semiconductor device according to a second embodiment of the invention which is constructed by mounting a semiconductor element 11 on a heat-releasable metal plate 17 as shown in Figs. 3A and 3B. An envelope 15 shown in Figs. 2A and 2B has a length of 19 mm, width of 6.3 mm and thickness of 3.5 mm. An envelope 15 shown in Figs. 3A and 3B has a length of 30 mm, width of 15 mm and thickness of 3 mm. A heat-releasable metal plate has a thickness of 2 mm. In both first and second embodiments, an electrically insulating sealing material is formed of phenol novolak type epoxy resin.

P-type resistor elements 12, 13 whose sheet resistance indicates 150 $\Omega \cdot cm^2$ and which have a length of 200 microns and width of 40 microns are formed by impurity diffusion in an N-type single crystal silicon plate 11 whose main surface is of a {100} crystal plane and which was initially separated along a cleavage plane, that is, in the direction of a <110> crystal axis. One of said P-type resistor elements 12, 13 is set in parallel with said <110> crystal axis, and the other is set perpendicular thereto. Rates of variations $\delta\rho_x$, $\delta\rho_y$ in the resistances of the resistor elements 12, 13 indicate values given in Fig. 5, when the above-mentioned <110> crystal axis defines angles of 0° and 45° with the lengthwise axis of the envelope 15.

N-type resistor elements 12, 13 whose sheet resistance indicates 20 $\Omega \cdot cm^2$ and which have a length of 200 microns and width of 40 microns are formed by impurity diffusion in a P-type. Single crystal silicon plate 11 whose crystal plane is denoted by {100} and which was initially separated along a cleavage plane, that is, in the direction of the <100> crystal axis. One of said N-type resistor elements 12, 13 is set in parallel with said <100> crystal axis, and the other is set perpendicular thereto. Rates of variations $\delta\rho_x$, $\delta\rho_y$ in the resistances of the resistor elements 12, 13 indicate values given in Fig. 6, when the above-mentioned <100> crystal axis defines angles of 0° and 45° with the lengthwise axis of the envelope 15.

P-type resistor elements 12, 13 whose sheet resistance indicates 150 $\Omega \cdot cm^2$, and which have a length of 200 microns and width of 40 microns are formed by impurity diffusion in an N-type single crystal silicon plate 11 whose crystal plane is denoted by {111} and which was initially separated along a cleavage plane, that is, in the direction of the <110> or <211> crystal axis. One of said P-type resistor elements 12, 13 is set in parallel with the <110> crystal axis, and the other is set also in parallel with the <211> crystal axis. Rates of variations $\delta\rho_x$, $\delta\rho_y$ in the resistances of the resistor elements 12, 13 indicate values given in Fig. 7 when the above-mentioned <110> or <211> crystal axis defines angles of 0° and 45° with the lengthwise axis of the envelope 15.

As seen from data given in Figs. 5 to 7, a difference between the rate of variations $\delta\rho_x$ in the resistance of the resistor element 12 and the rate of variations $\delta\rho_y$ in the resistance of the resistor element 13 can be reduced by forming said resistor elements 12, 13 in a single crystal silicon plate 11 in a state inclined at an angle of substantially 45° to the lengthwise axis of envelope 15. Therefore, a synthetic resin-sealed semiconductor device embodying this invention has the advantage that the rate of variations in the properties of semiconductor circuit elements can be more reduced than in the prior art similar semiconductor device, namely it is possible to suppress variations in the D.C. bias voltage of, for example, a differential amplifier.

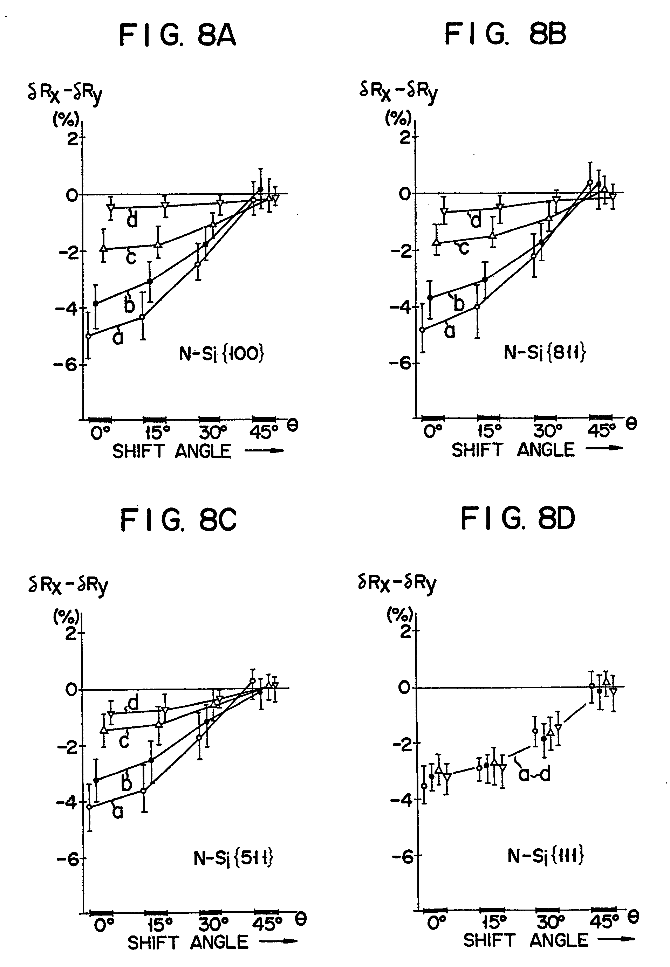

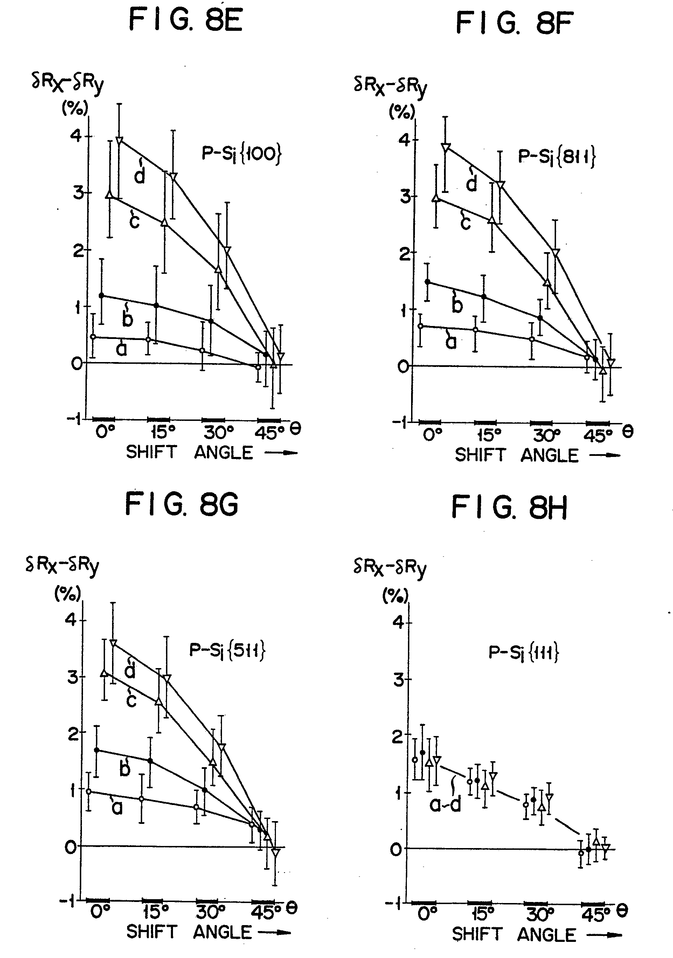

Figs. 8A to 8H show the differences ($\delta\rho_x - \delta\rho_y$) in the rates of variations in resistance between the resistor elements 12, 13 used with various samples constructed by changing the crystal plane of a semiconductor crystal, the orientation of the resistor elements 12, 13, and an angle defined by a mount of a semiconductor element with the envelope 15. Data given in Figs. 8A to 8H denote average values of the differences in the rates of variations in resistance between the resistor elements 12, 13 used with each of fifteen samples which were obtained with respect to the orientations $\alpha$ (0°, 15°, 30°, 45°) of the resistor elements 12, 13. The data were obtained by taking the angles $\theta$ defined by a mount with the envelope 15 to be 0°, 15°, 30°, 45°, and indicating the orientations $\alpha$ of the resistor elements 12, 13 relative to the prescribed crystal axis as 0°, 15°, 30°, 45° and using these orientation values as parameters. Throughout Figs. 8A to 8H, curve *a* denotes $-\alpha=0°$; curve *b* shows $\alpha=15°$; curve *c* indicates $\alpha=30°$; and curve *d* represents $\alpha=45°$.

The above-mentioned experiments were carried out under the following conditions:

TABLE 1

| | Semiconductor substrate main crystal plane | Resistor elements | | |
| --- | --- | --- | --- | --- |
| | | Reference crystal axis | Conductivity type | Impurity concentration |
| a | N-Si{100} | <110> | | |
| b | N-Si{811} | <01$\bar{1}$> | P | $8\times10^{18}$ cm$^{-3}$ |
| c | N-Si{511} | <01$\bar{1}$> | | |
| d | N-Si{111} | <110> | | |
| e | P-Si{100} | <110> | | |
| f | P-Si{811} | <01$\bar{1}$> | N | $5\times10^{19}$ cm$^{-3}$ |
| g | P-Si{511} | <01$\bar{1}$> | | |
| h | P-Si{111} | <110> | | |

The above-mentioned experiments were carried out with a semiconductor element 11 constructed by forming resistor elements 12, 13 within a central region measuring 2 mm×2 mm of a single crystal silicon plate 11 measuring 3 mm×3 mm×0.3 mm and sealing the plate assembly in a 36 pin DIP type envelope 15 which was prepared from synthetic resin and had a length of 45 mm, width of 12 mm and thickness of 3 mm. The rates of variations in the resistances of the resistor elements 12, 13 were determined as follows.

First, determination was made of the resistances $R_x(w)$, $R_y(w)$ of the resistor elements 12, 13, before the single crystal silicon plate 11 was sealed in an envelope prepared from synthetic resin. Later, determination was made of the resistances $R_x(M)$, $R_y(M)$ of the resistor elements 12, 13, after the semiconductor plate 11 was sealed in the envelope formed of synthetic resin. Thereafter, the rates of variations $\delta\rho_x$, $\delta\rho_y$ in the resistances of the resistor elements 12, 13 were determined as follows:

$$\delta\rho_x=\{R_x(M)-R_x(w)\}/R_x(w)$$

$$\delta\rho_y=\{R_y(M)-R_y(w)\}/R_y(w)$$

Differences ($\delta\rho_x - \delta\rho_y$) in the rates of variations in the resistance between the resistor elements 12, 13 were figured out. Said differences were averaged through the fifteen samples, thereby finally determining the rates of variations in the resistance of the resistor elements 12, 13.

Data given in Figs. 8A to 8H show that where the mount of the semiconductor pellet 11 is inclined at an angle of substantially 45° (45°±5°) to the lengthwise axis of the envelope 15, namely, current is made to flow through the resistor elements 12, 13 in a direction inclined at an angle of substantially 45° (45°±5°) to the lengthwise axis of the envelope 15, then the rates of variations in the resistances of the resistor elements 12, 13 can be made equal to each other. Since the properties of the semiconductor circuit elements of a semiconductor device embodying this invention are fully retained even after the semiconductor device is sealed in an envelope prepared from synthetic resin, the present synthetic resin-sealed semiconductor device has been proved to excellently serve practical purposes. Further as previously described, it is shown to be preferred to mount the semiconductor pellet 11 at an angle θ of substantially 45° (45°±5°) to the lengthwise axis of the envelope 15, regardless of the orientation of the resistor elements 12, 13. The reason for this is that the terms $\pi'_{11}$, $\pi'_{12}$, $\pi'_{22}$, $\pi'_{31}$ given in the aforementioned formulas (6a), (6b) are unrelated to the orientation of the resistor elements 12, 13 arranged at right angles to each other with respect to all crystal planes, and the relationships of $\pi'_{11} \approx \pi'_{22}$, $\pi'_{21} \approx \pi'_{12}$ are always satisfied.

With a semiconductor device embodying this invention, an envelope which is prepared from a synthetic resin with a rectangular cross section and in which a single crystal silicon substrate having a rectangular cross section is sealed comprises a crosswise wall and lengthwise wall having different thickness from each other. Consequently, the envelope applies stresses of different magnitudes to the crosswise walls and lengthwise walls of the single crystal silicon substrate having a rectangular cross section. As a result, a plurality of resistor elements formed in the single crystal silicon substrate are prevented from varying in resistance at different rates.

The envelope prepared from a synthetic resin may have a square or oblong cross section. When sealed in an envelope having a square cross section, the single crystal silicon substrate should have a rectangular cross section. When sealed in an envelope having an oblong cross section, the single crystal silicon substrate should have a rectangular cross section a square or oblong cross section unsimilar to the rectangular cross section of said envelope.

It is necessary to provide at least two resistor elements, and these elements should preferably be inclined at angle of substantially 45° to the lateral sides of the envelope. The single crystal silicon substrate and resistor elements may be of the P or N conductivity type. However, their main plane or surface should be formed of {100}, {811}, {511} or {111} crystal plane in order to enable the subject synthetic resin-sealed semiconductor device to display a sufficient effect. The main plane of said substrate and resistor element is particularly preferred to be formed of {100} or {111} crystal plane.

**Claims**

1. A synthetic resin-sealed semiconductor device comprising an envelope made of a synthetic resin, a single crystal silicon crystal plate which is formed with a rectangular shape and sealed in the envelope, the crosswise sides of said plate undergoing stresses of a different magnitude from those applied to the lengthwise sides of said plate, and the main plane being formed of a {100}, {811}, {511}, or {111} crystal plane; and at least a pair of resistor elements formed in the main plane of the single crystal silicon plate to extend at right angles with each other, characterized in that the lengthwise sides and the crosswise sides of the envelope form a rectangle and that the lengthwise sides of the single crystal silicon plate and the direction in which the pair of resistor elements extend define an angle of substantially 45° with the lengthwise sides of the envelope.

2. The synthetic resin-sealed semiconductor device according to claim 1, characterized in that the envelope has an oblong cross section; and stresses of different magnitudes are applied to the lengthwise and crosswise sides of the rectangular cross section of the single crystal silicon plate.

3. The synthetic resin-sealed semiconductor device according to claim 2, characterized in that the lengthwise sides of the oblong cross section of the envelope are longer than the crosswise sides thereof.

4. The synthetic resin-sealed semiconductor device according to claim 3, characterized in that the resistor elements are arranged at an angle of 45°±5° to the sides of the envelope.

5. The synthetic resin-sealed semiconductor device according to claim 4, characterized in that the single crystal silicon substrate has one conductivity type, and the resistor elements have the opposite conductivity type.

6. The synthetic resin-sealed semiconductor device according to claim 5, characterized in that the single crystal silicon substrate has a P conductivty type, and a main plane of {100} crystal plane; and one of the pair of resistor elements extends in a direction of [100] crystal axis and the other resistor element extends in a direction intersecting said [100] crystal axis at right angles.

7. The synthetic resin-sealed semiconductor device according to claim 5, characterized in that the single crystal silicon substrate has a P conductivity type, and a main plane of {100} crystal plane; and one of the pair of resistor elements extends in a direction of a [110] crystal axis, and the other resistor element extends in a direction intersecting said [110] crystal axis at right angles.

8. The synthetic resin-sealed semiconductor device according to claim 5, characterized in that the single crystal silicon substrate has a P conductivity type, and a main plane of {111} crystal plane; and one of the pair of resistor elements extends in a direction of a [110] crystal axis, and the other resistor element extends in a direction intersecting said [110] crystal axis at right angles.

9. The synthetic resin-sealed semiconductor device according to claim 5, characterized in that the single crystal silicon substrate has a P conductivity type, and a main plane of {111} crystal plane; and one of the pair of resistor elements extends in a direction of a [211] crystal axis, and the other resistor element extends in a direction intersecting said [211] crystal axis at right angles.

10. The synthetic resin-sealed semiconductor device according to claim 5, characterized in that the single crystal silicon substrate has a P conductivity type, and a main plane of {811} crystal plane; and one of the pair of resistor elements extends in a direction of a [011] crystal axis, and the other resistor element extends in a direction intersecting said [011] crystal axis at right angles.

11. The synthetic resin-sealed semiconductor device according to claim 5, characterized in that the single crystal silicon substrate has P conductivity type and a main plane of {511} crystal plane; and one of the pair of resistor elements extends in a direction of a [011] crystal axis, and the other resistor element extends in a direction intersecting said [011] crystal axis at right angles.

**Revendications**

1. Dispositif semi-conducteur enrobé de résine synthétique, comprenant une enveloppe faite d'une résine synthétique, une plaquette de silicium mono-cristallin de forme rectangulaire et enfermée dans l'enveloppe, les côtés transversaux de ladite plaquette subissant des contraintes d'une valeur différente de celles appliquées aux côtés longitudinaux de ladite plaquette et le plan principal étant formé d'un plan cristallin (100), (811), (511) ou (111); et au moins une paire d'éléments de résistance formés dans le plan principal de la plaquette de silicium monocristallin, disposés perpendiculairement entre eux, caractérisé en ce que les côtés longitudinaux et les côtés transversaux de l'enveloppe forment un rectangle et que les côtés longitudinaux de la plaquette de silicium mono-cristallin et la direction dans laquelle sont disposés les deux éléments de résistance définissent un angle de 45° par rapport aux côtés longitudinaux de l'enveloppe.

2. Dispositif semi-conducteur enrobé de résine synthétique selon la revendication 1, caractérisé en ce que l'enveloppe a une section ovale, et des contraintes de valeurs différentes sont appliquées aux côtés longitudinaux et transversaux de la section rectangulaire de la plaquette de silicium mono-cristallin.

3. Dispositif semi-conducteur enrobé de résine synthétique selon la revendication 2, caractérisé en ce que les côtés longitudinaux de la section ovale de l'enveloppe sont plus longs que ses côtés transversaux.

4. Dispositif semi-conducteur enrobé de résine synthétique selon la revendication 3, caractérisé en ce que les éléments de résistance sont disposées sous un angle de 45° (±5°) par rapport aux côtés de l'enveloppe.

5. Dispositif semi-conducteur enrobé de résine synthétique selon la revendication 4, caractérisé en ce que le substrat de silicium mono-cristallin a un type de conductivité et les éléments de résistance ont le type de conductivité opposé.

6. Dispositif semi-conducteur enrobé d'une résine synthétique selon la revendication 5, caractérisé en ce que le substrat de silicium monocristallin est du type de conductivité P et un plan principal du plan cristallin (100), et l'un des deux éléments de résistance s'étend dans une direction d'axe cristallin (100) tandis que l'autre élément de résistance s'étend dans une direction coupant ledit axe cristallin (100) à angle droit.

7. Dispositif semiconducteur enrobé de résine synthétique selon la revendication 5, caractérisé en ce que le substrat de silicium mono-cristallin est du type de conductivité P et à un plan principal du plan cristallin (100), et l'un des deux éléments de résistance s'étend dans une direction d'un axe cristallin (110) tandis que l'autre élément de résistance s'étend dans une direction coupant à angle droit ledit axe cristallin (110).

8. Dispositif semi-conducteur enrobé de résine synthétique selon la revendication 5, caractérisé en ce que le substrat de silicium mono-cristallin est du type de conductivité P et un plan principal du plan cristallin (111), et l'un des deux éléments de résistance s'étend dans une direction d'un axe cristallin (110) et l'autre élément de résistance s'étend dans une direction coupant à angle droit ledit axe cristallin (110).

9. Dispositif semi-conducteur enrobé de résine synthétique selon la revendication 5, caractérisé en ce que le substrat de silicium mono-cristallin est du type de conductivité P et un plan principal du plan cristallin (111), et l'un des deux éléments de résistance s'étend dans une direction d'un axe cristallin (211) tandis que l'autre éléments de résistance s'étend dans une direction coupant à angle droit ledit axe cristallin (211).

10. Dispositif semi-conducteur enrobé de résine synthétique selon la revendication 5, caractérisé en ce que le substrat de silicium mono-cristallin est du type de conductivité P, avec un plan principal du plan cristallin (811), et l'un des deux éléments de résistance s'étend dans une direction d'un axe cristallin (011) tandis que l'autre élément de résistance s'étend dans une direction coupant à angle droit ledit axe cristallin (011).

11. Dispositif semi-conducteur enrobé de résine synthétique selon la revendication 5, caractérisé en ce que le substrat de silicium mono-cristallin est du type de conductivité P avec un plan principal du plan cristallin (511), et l'un des deux éléments de résistance s'étend dans une direction d'un axe cristallin (011) tandis que l'autre élément de résistance s'étend dans une direction coupant à angle droit ledit axe cristallin (011).

**Patentansprüche**

1. In Kunstharz eingebettete Halbleitervorrichtung, umfassend eine Umhüllung oder Kapsel aus einem Kunstharz, ein Einkristal-Siliziumplättchen, das mit einer rechteckigen Form ausgebildet und in die Kapsel hermetisch eingeschlossen ist und dessen Querseiten Spannungen einer unterschiedlichen Größe als die Spannungen, die auf die Langseiten des Plättchens einwirken, unterworfen sind, wobei die Hauptebene aus einer {100}-, {811}-, {511}- oder {111}-Kristallebene gebildet ist, sowie mindestens zwei in der Hauptebene des Einkristall-Siliziumplättchens sich unter einem rechten Winkel zueinander erstreckend ausgebildete Widerstandselemente, dadurch gekennzeichnet, daß die Langseiten und die Querseiten der Kapsel ein Rechteck bilden und daß die Langseiten des Einkristall-Siliziumplättchens und die Richtung, in welche sich die beiden Widerstandselemente erstrecken, einen Winkel von praktisch 45° mit den Langseiten der Kapsel festlegen.

2. In Kunstharz eingebettete Halbleitervorrichtung nach Anspruch 1, dadurch gekennzeichnet, daß die Umhüllung oder Kapsel einen länglichen Querschnitt besitzt und daß Spannungen unterschiedlicher Größen auf die Lang- und Querseiten des rechteckigen Querschnitts des Einkristall-Siliziumplättchens einwirken.

3. In Kunstharz eingebettete Halbleitervorrichtung nach Anspruch 2, dadurch gekennzeichnet, daß die Langseiten des länglichen Querschnitts der Kapsel länger sind als ihre Querseiten.

4. In Kunstharz eingebettete Halbleitervorrichtung nach Anspruch 3, dadurch gekennzeichnet, daß die Widerstandselemente unter einem Winkel von 45°±5° zu den Seiten der Kapsel angeordnet sind.

5. In Kunstharz eingebettete Halbleitervorrichtung nach Anspruch 4, dadurch gekennzeichnet, daß das Einkristall-Siliziumsubstrat bzw. -plättchen den einen Leitungstyp besitzt und die Widerstandselemente den entgegengesetzten Leitungstyp aufweisen.

6. In Kunstharz eingebettete Halbleitervorrichtung nach Anspruch 5, dadurch gekennzeichnet, daß das Einkristall-Siliziumsubstrat einen P-Leitungstyp und eine Hauptebene aus der {100} -Kristallebene aufweist und eines der beiden Widerstandselemente sich in einer Richtung der [100] -Kristallachse und das andere Widerstandselement sich in einer die [100] -Kristallachse unter einem rechten Winkel schneidenden Richtung erstreckt.

7. In Kunstharz eingebettete Halbleitervorrichtung nach Anspruch 5, dadurch gekennzeichnet, daß das Einkristall-Siliziumsubstrat einen P-Leitungstyp und eine Hauptebene aus der {100} -Kristallebene aufweist und das eine der beiden Widerstandselemente sich in einer Richtung einer [100] -Kristallachse und das andere Widerstandselemente sich in einer die [100] -Kristallachse unter einem rechten Winkel schneidenden Richtung erstreckt.

8. In Kunstharz eingebettete Halbleitervorrichtung nach Anspruch 5, dadurch gekennzeichnet, daß das Einkristall-Siliziumsubstrat einen P-Leitungstyp und eine Hauptebene aus der {111}-Kristallebene aufweist und das eine der beiden Widerstandselemente sich in einer Richtung einer [110] -Kristallachse und das andere Widerstandselement sich in einer die [110] -Kristallachse unter einem rechten Winkel schneidenden Richtung erstreckt.

9. In Kunztharz eingebettete Halbleitervorrichtung nach Anspruch 5, dadurch gekennzeichnet, daß das Einkristall-Siliziumsubstrat einen P-Leitungstyp und eine Hauptebene aus der {111} -Kristallebene aufweist und das eine der beiden Widerstandselemente sich in einer Richtung einer [211] -Kristallachse und das andere Widerstandselement sich in einer die [211] -Kristallachse unter einem rechten Winkel schneidenden Richtung erstreckt.

10. In Kunstharz eingebettete Halbleitervorrichtung nach Anspruch 5, dadurch gekennzeichnet, daß das Einkristall-Siliziumsubstrat einen P-Leitungstyp und eine Hauptebene aus der {811} -Kristallebene aufweist und das eine der beiden Widerstandselemente sich in einer Richtung einer [011] -Kristallachse und das andere Widerstandselement sich in einer die [011] -Kristallachse unter einem rechten Winkel schneidenden Richtung erstreckt.

11. In kunstharz eingebettete Halbleitervorrichtung nach Anspruch 5, dadurch gekennzeichnet, daß das Einkristall-Siliziumsubstrat einen P-Leitungstyp und eine Hauptebene aus der {511} -Kristallebene aufweist und das eine der beiden Widerstandselemente sich in einer Richtung einer [011] -Kristallachse und das andere Widerstandselement sich in einer die [011] -Kristallachse unter einem rechten Winkel schneidenden Richtung erstreckt.

# F I G. 1

# F I G. 2A

# F I G. 2B

# F I G. 3A

# F I G. 3B

# F I G. 4A

# F I G. 4B

0 035 331

F I G. 5

F I G. 6

F I G. 7

## F I G. 8A

N-Si {100}

SHIFT ANGLE ⟶

## F I G. 8B

N-Si {811}

SHIFT ANGLE ⟶

## F I G. 8C

N-Si {511}

SHIFT ANGLE ⟶

## F I G. 8D

N-Si {111}

SHIFT ANGLE ⟶

FIG. 8E

FIG. 8F

FIG. 8G

FIG. 8H